Europäisches Patentamt

European Patent Office

Office européen des brevets

(11) Veröffentlichungsnummer: **0 139 207**
**B1**

(12) **EUROPÄISCHE PATENTSCHRIFT**

(45) Veröffentlichungstag der Patentschrift: **13.06.90**

(51) Int. Cl.⁵: **H 03 M 7/04**

(21) Anmeldenummer: **84110829.3**

(22) Anmeldetag: **11.09.84**

(54) **Schaltung zur CSD-Codierung einer im Zweierkomplement dargestellten, binären Zahl.**

(30) Priorität: **29.09.83 DE 3335386**

(43) Veröffentlichungstag der Anmeldung:
**02.05.85 Patentblatt 85/18**

(45) Bekanntmachung des Hinweises auf die
Patenterteilung:
**13.06.90 Patentblatt 90/24**

(84) Benannte Vertragsstaaten:
**BE DE FR GB IT**

(56) Entgegenhaltungen:
**NACHRICHTEN ELEKTRONIK, Band 36, Nr. 3,
März 1982, Seiten 106, 117-119, Heidelberg, DE;
V. LEESEMANN: "Seriell/Parallel-Multiplizierer
für die digitale Signalverarbeitung, Teil 2"**

**IEEE TRANSACTIONS ON ACOUSTICS,
SPEECH, AND SIGNAL PROCESSING, Band
ASSP-24, Nr. 1, Februar 1976, Seiten 76-86, New
York, US; A. PELED: "On the hardware
implementation of digital signal processors"**

(73) Patentinhaber: **Siemens Aktiengesellschaft
Wittelsbacherplatz 2
D-8000 München 2 (DE)**

(72) Erfinder: **Rainer, Alois, Dipl.-Ing.
Millevistrasse 52/11
A-9500 Villach (AT)**

Courier Press, Leamington Spa, England.

**Beschreibung**

Die Erfindung bezieht sich auf eine Schaltung zur CSD-Codierung einer im Zweierkomplement dargestellten, binären Zahl.

Unter einem CSD-Code (Canonical-Signed-Digit-Code) wird ein binärer Code verstanden, bei dem es ausgeschlossen ist, daß zwei benachbarte Binärstellen jeweils eine logische "1" aufweisen. Das bedeutet, daß in einer solchen binären Darstellung sogenannte "1"-Blöcke fehlen. Der Zeitschrift "IEEE Transactions on Acoustics, Speech and Signal Processing" Vol. ASSP-24, Nr. 1, Februar 1976, Seiten 76 bis 86, ist entnehmbar, daß der CSD-Code hauptsächlich bei der digitalen Datenverarbeitung verwendet wird, und zwar insbesondere zur Darstellung von Multiplikatoren, da jedes "1"-Bit eines solchen Multiplikators je nach seinem Vorzeichen einen Additions- oder Subtraktionsvorgang bedeutet und die Zahl dieser Vorgänge möglichst niedrig gehalten werden soll. Während bei einem allgemeinen binären Code einer N-stelligen Zahl durchschnittlich etwa $N/2$ "1"-Bits auftreten, reduziert sich die durchschnittliche Anzahl solcher Signale bei einem CSD-Code auf etwa $N/3$.

Aufgabe der Erfindung ist es, eine Schaltung zur CSD-Codierung von binären Zahlen anzugeben, die einfach aufgebaut ist und eine möglichst große Arbeitsgeschwindigkeit gewährleistet. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß die Schaltung aus einfachen logischen Schaltungsgliedern zusammengesetzt ist und daß die CSD-Codierung einer binären Zahl insbesondere nur eine Zeitspanne erfordert, die drei Gatterlaufzeiten entspricht.

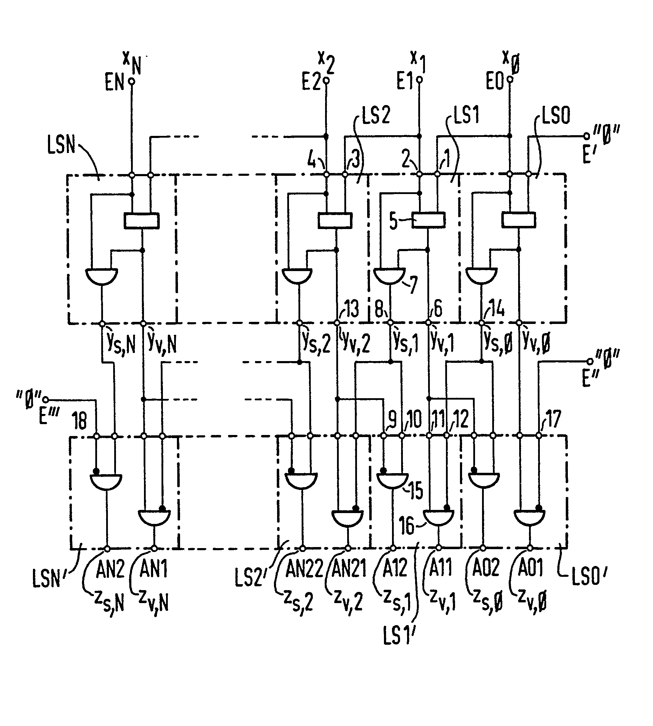

Die Erfindung wird nachfolgend anhand der Zeichnung näher erläutert.

Die Eingänge der erfindungsgemäßen Schaltung sind mit E0 bis EN bezeichnet. Diesen werden jeweils die Bits $x_0, x_1 \ldots x_N$ einer binären Zahl zugeführt, wobei $x_0$ das Bit niedrigster Wertigkeit bezeichnet, $x_N$ das Bit höchster Wertigkeit. Jeweils zwei dieser Eingänge, die einander unmittelbar benachbart sind, werden mit den beiden Eingängen eines logischen Schaltungsgliedes verbunden. In der Zeichnung sind zum Beispiel die Schaltungseingänge E0 und E1 mit den Eingängen 1 und 2 des logischen Schaltungsgliedes LS1 beschaltet, die Schaltungseingänge E1 und E2 mit den Eingängen 3 und 4 des logischen Schaltungsgliedes LS2 und so weiter. Die Schaltungseingänge E (N−1) und EN liegen an den Eingängen des logischen Schaltungsgliedes LSN, während der Schaltungseingang E0 zusammen mit einem weiteren Schaltungseingang E', der ständig mit einer "0" beschaltet ist, an den Eingang des logischen Schaltungsgliedes LS0 geführt ist.

Von den logischen Schaltungsgliedern LS0 bis LSN, die untereinander gleichartig aufgebaut sind, wird im folgenden nur LS1 näher beschrieben. Wie aus der Zeichnung ersichtlich ist, sind die Eingänge 1, 2 von LS1 mit zwei Eingängen einer Exklusiv- ODER-Schaltung 5 verbunden, deren Ausgang den ersten Ausgang 6 von LS1 darstellt.

Weiterhin ist der Eingang 2, der mit dem höherwertigen Bit $x_1$ belegt ist (1 ist ja mit $x_0$ beschaltet), mit dem ersten Eingang eines UND-Gliedes 7 verbunden, dessen zweiter Eingang an den Ausgang von 5 gelegt ist. Der Ausgang des UND-Gliedes 7 bildet den zweiten Ausgang 8 von LS1. Am Ausgang 6 ist ein Betragsbit $y_{v,1}$ abgreifbar, das aus den beiden eingangsseitigen Bits $x_0$ und $x_1$ abgeleitet wird, während am Ausgang 8 ein Vorzeichenbit $y_{s,1}$ auftritt, das dem Betragsbit $y_{v,1}$ zugeordnet ist. Dabei bedeutet $y_{s,1}=0$ ein positives Vorzeichen, während $y_{s,1}=1$ ein negatives Vorzeichen darstellt. In gleicher Weise werden über die anderen logischen Schaltungsglieder LS0, LS2 ... LSN aus den jeweils eingangsseitigen Bitpaaren ("0", $x_0$), ($x_1$, $x_x$) ... ($x_{N-1}$, $x_N$) die Betragsbits $y_{v,0}$, $y_{v,2}$ ... $y_{v,N}$ abgeleitet, denen weiterhin die Vorzeichenbits $y_{s,0}$, $y_{s,2}$ ... $y_{s,N}$ zugeordnet sind.

Jedem der logischen Schaltungsglieder LS0 bis LSN ist ein weiteres logisches Schaltungsglied LS0' bis LSN' zugeordnet, wobei diese wieder untereinander gleichartig aufgebaut sind, so daß nur eines von ihnen, zum Beispiel LS1', im folgenden näher beschrieben wird. LS1' weist vier Eingänge 9 bis 12 auf, von denen die Eingänge 10 und 11 mit den Ausgängen 8 und 6 von LS1 beschaltet sind. Der Eingang 9 ist mit dem für das Betragsbit $y_{v,2}$ vorgesehenen Ausgang 13 von LS2 verbunden, während der Eingang 12 an den für das Vorzeichenbit $y_{s,0}$ vorgesehenen Ausgang 14 von LS0 geführt ist. Der Eingang 9 ist weiterhin über einen Inverter mit dem ersten Eingang eines UND-Gliedes 15 verbunden, wobei dieser Inverter auch wie darstellt in das Glied 15 einbezogen sein kann, während der Eingang 10 mit dem zweiten Eingang des UND- Gliedes 15 beschaltet ist. Der Eingang 11 von LS1' ist mit dem ersten Eingang eines UND-Gliedes 16 verbunden, wobei der Eingang 12 über einen Inverter an den zweiten Eingang von 16 geführt ist. In der Zeichnung ist dieser Inverter wieder in das Glied 16 einbezogen, wobei der betreffende Eingang von 16 als invertierender Eingang dargestellt ist. Die Ausgänge der UND-Glieder 15 und 16 bilden jeweils die Ausgänge A12 und A11 des weiteren logischen Schaltungsgliedes LS1'.

Aus den Größen $y_{s,1}$ und $y_{v,1}$ sowie $y_{v,2}$ und $y_{s,0}$ wird über LS1' ein Betragsbit $z_{v,1}$ abgeleitet, das am Ausgang A11 auftritt. Zu diesem gehört ein ebenfalls aus den vorstehend genannten Größen abgeleitetes Vorzeichenbit $z_{s,1}$, das am Ausgang A12 abgreifbar ist. In analoger Weise werden über die weiteren logischen Schaltungsglieder LS0', LS2' ... LSN' entsprechende Betragsbits $z_{v,0}$, $z_{v,2}$ ... $z_{v,N}$ abgeleitet, die jeweils an den Ausgängen A01, A21 ..., AN1 zur Verfügung stehen, sowie zugehörige Vorzeichenbits $z_{s,0}$, $z_{s,2}$ ... $z_{s,N}$, die an den Ausgängen A02, A22 ... AN2 auftreten.

Ganz allgemein sind bei jedem der weiteren logischen Schaltungsglieder LS0' . . . LSN' jeweils zwei der vier Eingänge mit den beiden Ausgängen des zugehörigen logischen Schaltungsgliedes LS0 . . . LSN verbunden, während ein dritter Eingang mit dem Betragsausgang des dem zugehörigen logischen Schaltungsglied unmittelbar benachbarten logischen Schaltungsgliedes nächsthöherer Wertigkeit und der vierte Eingang mit dem Vorzeichenausgang des dem zugehörigen logischen Schaltungsglied unmittelbar benachbarten logischen Schaltungsgliedes nächst niedrigerer Wertigkeit beschaltet ist. Der vierte Eingang 17 des weiteren logischen Schaltungsgliedes LS0' ist mit einem Schaltungseingang E'' verbunden der ständig mit einer "0" belegt ist, während der dritte Eingang 18 von LSN' mit einem weiteren Schaltungseingang E''' beschaltet ist, der ständig mit einer "0" beaufschlagt ist. Die an den Ausgängen A01 bis AN2 abgreifbare Bitkombination $z_{v,0}$, $z_{s,0}$ . . . $z_{v,N}$, $z_{s,N}$ stellt das von der eingangsseitig anliegenden Zahl $x_0$ . . . $x_N$ abgeleitete, CSD-codierte binäre Ausgangssignal der Schaltung dar.

Für die Wirkungsweise der Schaltung ist es von wesentlicher Bedeutung, daß jedes der logischen Schaltungsglieder LS0 . . . LSN, z.B. das Glied LS1, an seinem Betragsausgang, z.B. 6, nur dann eine logische "1" abgibt, wenn an seinen Eingängen unterschiedliche Bits anliegen. Weiterhin tritt an dem zugehörigen Vorzeilchenausgang, z.B. 8, des betrachteten Schaltungsgliedes nur dann eine "1" auf, wenn das eingangsseitige Bit höherer Wertigkeit, z.B. $x_1$, aus einer logischen "1" besteht, das eingangsseitige Bit niedrigerer Wertigkeit, z.B. $x_0$, jedoch aus einer logischen "0". Nur in diesem Fall ist also dem Betragsbit "1" am Ausgang, z.B. 6, des betrachteten logischen Schaltungsgliedes ein negatives Vorzeichen zugeordnet.

Für $x_0=0$ und $x_1=1$ ergibt sich beispielsweise $y_{v,1}=1$ und $y_{s,1}=1$. Nimmt man weiter an, daß $x_2=0$, so ergeben sich an den Ausgängen von LS2 die Signale $y_{v,2}=1$ und $y_{s,2}=0$. Damit haben zwei nebeneinanderliegende logische Schaltungsglieder, und zwar LS2 und LS1 eine vorzeichenbehaftete ausgangsseitige Bitkombination 1, −1, wobei das höherwertige logische Schaltungsglied, nämlich LS2, zuerst genannt ist. Nur aus dieser Bitkombination leiten die LS2 und LS1 zugeordneten, weiteren logischen Schaltungsglieder, nämlich LS2' und LS1', eine CSD-codierte Bitkombination 0, 1 ab, was in einzelnen folgenden Ausgangssignalen entspricht: $z_{v,1}=1$, $z_{s,1}=0$, $z_{v,2}=0$ und $z_{s,2}=0$. Hierzu ist vorausgesetzt, daß das Vorzeichenbit $y_{s,0}=0$, was sich aber aus der obengemachten Annahme $x_0=0$ ergibt. Wenn die übrigen logischen Schaltungsglieder, d.h. LS0, LS3 . . . LSN, bei paarweiser Betrachtung keine solchen ausgangsseitigen Bitkombinationen 1, −1 aufweisen, werden ihre Bitkombinationen, d.h. die Signale $y_{v,0}$, $y_{s,0}$, $y_{v,3}$, $y_{s,3}$, . . . $y_{v,N}$, $y_{z,N}$ unverändert auf entsprechende Signale an den Ausgängen der weiteren logischen Schaltungsglieder, d.h. $z_{v,0}$, $z_{s,0}$, $z_{v,3}$, $z_{s,3}$ . . . $z_{v,N}$, $z_{s,N}$ übertragen.

Betrachtet man die Wirkungsweise eines weiteren logischen Schaltungsgliedes, z.B. LS1', so erkennt man, daß an seinem Betragsausgang A11 ein CSD-codiertes Betragsbit $z_{v,1}$ abgreifbar ist, das dem von dem zugeordneten logischen Schaltungsglied zugeführten Betragsbit $y_{v,1}$ dann entspricht, wenn das von dem benachbarten logischen Schaltungsglied niedrigerer Wertigkeit zugeführte Vorzeichenbit $y_{s,0}$ aus einer logischen "0" besteht. Andererseits wird das eingangsseitige Betragsbit $y_{v,1}$ dann negiert, wenn das Vorzeichenbit $y_{s,0}$ aus einer logischen "1" besteht. Am Vorzeichenausgang A12 des weiteren logischen Schaltungsgliedes LS1' ist ein CSD-codiertes Vorzeichenbit $z_{s,1}$ abgreifbar, das dann dem von dem zugehörigen Schaltungsglied zugeführten Vorzeichenbit $y_{s,1}$ entspricht, wenn das von dem benachbarten logischen Schaltungsglied höherer Wertigkeit zugeführte Betragsbit $y_{v,2}$ aus einer logischen "0" besteht, während eine logische "1" dieses Betragsbits zu einer Negation des zugeführten Vorzeichenbits $y_{s,1}$ führt. Die Wirkungsweise der logischen Schaltungsglieder LS0', LS2' . . . LSN' ist analog zu der vorstehend beschriebenen Wirkungsweise von LS1'.

## Patentansprüche

1. Schaltung zur CSD-Codierung einer im Zweierkomplement dargestellten, binären Zahl, dadurch gekennzeichnet, daß eine Reihe von ersten logischen Schaltungsgliedern (LS0 . . . LSN) mit jeweils zwei Eingängen (1, 2) und zwei Ausgängen (6, 8) vorgesehen sind, wobei den Eingängen (1, 2) dieser Schaltungsglieder die Bits ($x_0$, $x_1$) einander benachbarter Binärstellen der zu codierenden Zahl jeweils paarweise zugeführt werden, am ersten Ausgang (6) eines jeden solchen Schaltungsgliedes ein nach einer Exklusiv- ODER -Funktion von den beiden eingangsseitigen Bits ($x_0$, $x_1$) abgeleitetes Betragsbit ($y_{0,1}$) abgreifbar ist und am zweiten Ausgang (8) jeweils ein Vorzeichenbit ($y_{s,1}$) abgreifbar ist, das nur dann aus einer logischen "1" besteht, wenn das eingangsseitige Bit höherer Wertigkeit ($x_1$) aus einer logischen "1", das eingangsseitige Bit niedrigerer Wertigkeit ($x_0$) jedoch aus einer logischen "0" besteht, daß eine Reihe von zweiten logischen Schaltungsgliedern (LS0' . . . LSN') vorgesehen sind, an deren Ausgängen (A01 . . . AN2) eine CSD-codierte Bitkombination der binären Zahl abgreifbar ist, und daß die zweiten logischen Schaltungsglieder von jedem Paar einander unmittelbar benachbarter erster logischer Schaltungsglieder (LS1, LS2), deren Ausgänge eine Bitkombination "1, −1" aufweisen, wobei das Vorzeichenbit des diesem Paar (LS1, LS2) zugehörigen ersten Schaltungsgliedes höherer Wertigkeit (LS2) "0", das Betragsbit dieses Schaltungsgliedes "1", das Vorzeichenbit des diesem Paar (LS1, LS2) zugehörigen ersten Schaltungsgliedes niedrigerer Wertigkeit (LS1) "1" und das Betragsbit dieses letzteren Schaltungsgliedes "1" betragen, eine CSD-codierte Bitkombination "0, 1" ableiten, während die Bitkombinationen an den Ausgängen aller übrigen ersten logischen Schaltungsglieder (LS0, LS3 . . . LSN) unverändert

in die ausgangsseitige CSD-codierte Bitkombination der zweiten logischen Schaltungsglieder übernommen werden.

2. Schaltung nach Anspruch 1, dadurch gekennzeichnet, daß jedes der zweiten logischen Schaltungsglieder (LS1') vier Eingänge (9 bis 12) und zwei Ausgänge (A11, A12) aufweist, wobei den Eingängen das Betragsbit und das Vorzeichenbit eines zugeordneten ersten logischen Schaltungsgliedes (LS1) sowie das Vorzeichenbit des in Richtung auf niedrigere binäre Wertigkeiten unmittelbar benachbarten ersten logischen Schaltungsgliedes (LS0) und das Betragsbit des in Richtung auf höhere binäre Wertigkeiten unmittelbar benachbarten ersten logischen Schaltungsgliedes (LS2) zugeführt werden, daß an dem einen Ausgang (A11) ein CSD-codiertes Betragsbit $(z_{v,1})$ abgreifbar ist, das dem eingangsseitigen Betragsbit $(y_{v,1})$ dann entspricht, wenn das von dem benachbarten ersten logischen Schaltungsglied (LS0) zugeführte Vorzeichenbit $(y_{s,0})$ aus einer logischen "0" besteht, und dem negierten eingangsseitigen Betragsbit $(y_{v,1})$ dann entspricht, wenn das zuletzt genannte Vorzeichenbit $(y_{s,0})$ aus einer logischen "1" besteht, und daß an dem anderen Ausgang (A12) ein CSD-codiertes Vorzeichenbit $(z_{s,1})$ abgreifbar ist, das dann dem von dem zugehörigen ersten logischen Schaltungsglied (LS1) zugeführten Vorzeichenbit $(y_{s,1})$ entspricht, wenn das von dem benachbarten ersten logischen Schaltungsglied (LS2) zugeführte Betragsbit $(y_{v,2})$ aus einer logischen "0" besteht, während es dem negierten, von dem zugehörigen ersten logischen Schaltungsglied (LS1) zugeführten Vorzeichenbit $(y_{s,1})$ entspricht, wenn das zuletzt genannte Betragsbit $(y_{v,2})$ aus einer logischen "1" besteht.

3. Schaltung nach Anspruch 1 oder 2, dadurch gekennzeichnet, daß ein erstes logisches Schaltungsglied (LS1) ein Exklusiv-ODER-Glied (5) und ein erstes UND-Glied (7) enthält, wobei zwei Eingänge des Exklusiv-ODER-Gliedes (5) die Eingänge (1, 2) des logischen Schaltungsgliedes (LS1) darstellen, daß der erste Eingang des ersten UND-Gliedes (7) mit dem mit dem höherwertigen Bit $(x_1)$ belegten Eingang (2) dieses Schaltungsgliedes (LS1) verbunden ist, daß der zweite Eingang des ersten UND-Gliedes (7) mit dem Ausgang des Exklusiv-ODER-Gliedes (5) beschaltet ist und daß der Ausgang des Exklusiv-ODER-Gliedes (5) den Ausgang (6) für das Betragsbit $(y_{v,1})$ darstellt, während der Ausgang des ersten UND-Gliedes (7) den Ausgang (8) für das Vorzeichenbit $(y_{s,1})$ bildet.

4. Schaltung nach einem der Ansprüche 1 bis 3, dadurch gekennzeichnet, daß ein zweites logisches Schaltungsglied (LS1') ein zweites und ein drittes UND-Glied (15, 16) enthält, daß die zwei Eingänge des zweiten UND-Gliedes (15) jeweils mit dem für das Vorzeichenbit $(y_{s,1})$ vorgesehenen Ausgang (8) eines zugeordneten ersten logischen Schaltungsgliedes (LS1) und über einen Inverter mit dem für das Betragsbit $(y_{v,2})$ vorgesehenen Ausgang (13) des unmittelbar benachbarten ersten logischen Schaltungsgliedes höherer Wertigkeit (LS2) beschaltet sind, daß die zwei Eingänge des dritten UND-Gliedes (16) jeweils mit dem für das Betragsbit $(y_{v,1})$ vorgesehenen Ausgang (6) des zugehörigen ersten logischen Schaltungsgliedes (LS1) und über einen Inverter mit dem für das Vorzeichenbit $(y_{s,0})$ vorgesehenen Ausgang (14) des unmittelbar benachbarten ersten logischen Schaltungsgliedes niedrigerer Wertigkeit (LS0) beschaltet sind und daß der Ausgang des dritten UND-Gliedes (16) den Ausgang (A11) für das CSD-codierte Betragsbit $(z_{v,1})$ darstellt, während der Ausgang des zweiten UND-Gliedes den Ausgang (A12) für das CSD-codierte Vorzeichenbit $(z_{s,1})$ bildet.

**Revendications**

1. Circuit pour réaliser le codage, exécuté selon le code CSD, d'un nombre binaire représenté dans le système de complémentation à deux caractérisé par le fait qu'il est prévu une série de premiers éléments de circuit logiques (LS0 . . . LSN) possédant chacun deux entrées (1, 2) et deux sorties (6, 8), auquel cas les bits $(x_0, x_1)$ de deux chiffres binaires voisins du nombre devant être codé sont envoyés respectivement par couples aux entrées (1, 2) de ces éléments de circuit, un bit de valeur absolue $(y_{0,1})$ dérivé des deux bits $(x_0, x_1)$ présents sur le côté entrée, conformément à une fonction OU-Exclusif, peut être prélevé sur la première sortie (6) de chaque élément de circuit de ce type, et, sur la seconde sortie (8) on peut prélever respectivement un bit de signe $(y_{s,1})$ qui est constitué par un "1" logique uniquement lorsque le bit $(x_1)$ présent à l'entrée et possédant un poids supérieur est constitué par un "1" logique, mais que le bit présent à l'entrée et possédant le poids supérieur $(x_0)$ est constitué par un "0" logique, il est prévu une série de seconds éléments de circuit logiques (LS0' . . . LSN'), sur les sorties (A01 . . . AN2) desquelles on peut prélever une combinaison binaire, codée selon le code CSD, du nombre binaire, et que les seconds éléments de circuit logiques forment une combinaison binaire "0, 1", codée selon le code CSD, à partir de chaque couple de premiers éléments de circuit logiques (LS1, LS2), qui sont directement voisins et dont les sorties fournissent une combinaison binaire "1, −1", le bit de signe de poids supérieur (LS2) du premier élément de circuit associé à ce couple (LS1, LS2) étant "0", le bit de valeur absolue de cet élément de circuit étant "1", le bit de signe possédant la valeur la plus faible (LS1) de ce premier élément de circuit associé à ce couple (LS1, LS2) étant "1" et le bit de valeur absolue de ce dernier élément de circuit étant "1", tandis que les combinaisons binaires présentes sur les sorties de tous les autres premiers éléments de circuit logiques (LS0, LS3, . . . LSN) sont transférées en restant inchangées dans la combinaison binaire, codée selon le code CSD et présente à la sortie, du second élément de circuit logique.

2. Circuit suivant la revendication 1, caractérisé par le fait que chacun des seconds éléments de circuit logiques (LS1') comporte quatre entrées (9 à 12) et deux sorties (A11, A12), auquel cas le bit de valuer absolue et le bit de signe d'un premier élément de circuit logique (LS1) associé ainsi que le bit de signe du premier élément de circuit logiqué (LS0), directement voisin dans la direction des poids binaires plus faibles, et le bit de valeur absolue du premier élément de circuit logique (LS2) directement voisin dans la direction des poids binaires supérieurs, sont envoyés aux entrées, que sur une sortie (A11) peut être prélevé un bit de valeur absolue ($z_{v,1}$) codé selon le code CSD et qui correspond au bit de valeur absolue ($y_{v,1}$) présent sur le côté entrée lorsque le bit de signe ($y_{s,0}$) envoyé au premier élément de circuit logique (LS0) voisin est constitué par un "0", et correspond au bit de valeur absolue ($y_{v,1}$) présent sur le côté entrée et négativé, lorsque le bit de signe ($y_{s,0}$) indiqué en dernier est formé par un "1" logique, et que sur l'autre sortie (A12) on peut prélever un bit de signe ($z_{s,1}$) codé selon le code CSD et qui correspond au bit de signe ($y_{s,1}$) envoyé par le premier élément de circuit logique (LS1) associé, lorsque le bit de valeur absolue ($y_{v,2}$) envoyé par le premier élément de circuit logique (LS2) voisin, est formé par un "0" logique, tandis qu'il correspond au bit de signe ($y_{s,1}$) négativé, envoé par le premier élément de circuit logique (LS1) associé, lorsque le bit de valeur absolue ($y_{v,2}$), indiqué en dernier est formé par un "1" logique.

3. Circuit suivant la revendication 1 ou 2, caractérisé par le fait qu'un premier élément de circuit logique (LS1) contient une porte OU-Exclusif (5) et une première porte ET (7), deux entrées de la porte OU-Exclusif (5) représentant les entrées (1, 2) de l'élément de circuit logique (LS1), que la première entrée de la première porte ET (7) est reliée à l'entrée (2), occupée par le bit de poids supérieur ($x_1$), de cet élément de circuit (LS1), que la seconde entrée de la première porte ET (7) est reliée à la sortie de la porte OU-Exclusif (5), et que la sortie de la porte OU-Exclusif (5) constitue la sortie (6) pour le bit de valeur absolue ($y_{v,1}$), tandis que la sortie de la première porte ET (7) forme la sortie (8) pour le bit de signe ($y_{s,1}$).

4. Circuit selon l'une des revendications 1 à 3, caractérisé en ce qu'un second élément de circuit logique (LS1') contient des seconde et troisième portes (15, 16), que les deux entrées de la seconde porte ET (15) sont raccordées respectivement à la sortie (8) prévue pour le bit de signe ($y_{s,1}$) d'un premier élément de circuit logique (LS1) associé et, par l'intermédiaire d'un inverseur, à la sortie (13), prévue pour le bit de valeur absolue ($y_{v,2}$), du premier élément de circuit logique directement voisin, possédant un rang plus élevé (LS2), que les deux entrées de la troisième porte ET (16) sont raccordées respectivement à la sortie (6), prévue pour le bit de valeur ($y_{v,1}$), du premier élément de circuit logique (LS1) associé et, par l'intermédiaire d'un inverseur, à la sortie (14), prévue pour le bit de signe ($y_{s,0}$), du premier élément de circuit logique directement voisin possédant le rang inférieur (LS0), et que la sortie de la troisième porte ET (7) constitue la sortie (A11) pour le bit de valeur absolue ($z_{v,1}$) codée selon le code CSD, tandis que la sortie de la seconde porte ET forme la sortie (A12) du bit de signe ($z_{s,1}$) codé selon le code CSD.

**Claims**

1. Circuit for CSD coding of a complement-of-two binary number, characterized in that a number of first logical circuit sections (LS0 ... LSN) having in each case two inputs (1, 2) and two outputs (6, 8) is provided, the inputs (1, 2) of these circuit sections in each case being supplied pair by pair with the bits ($x_0$, $x_1$) of mutually adjacent binary positions of the number to be coded, at the first output (6) of each such circuit section an amount bit ($y_{0,1}$), which is derived from the two input bits ($x_0$, $x_1$) in accordance with an exclusive OR function can be picked up and at the second output (8) in each case a sign bit ($y_{s,1}$) can be picked up which only consists of a logical "1" when the most significant input bit ($x_1$) consists of a logical "1" but the least significant input bit ($x_0$) consists of a logical "0", that a number of second logical circuit sections (LS0' ... LSN') is provided at the outputs (A01 ... AN2) of which a CSD-coded bit combination of the binary number can be picked up, and that the second logical circuit sections derive a CSD-coded bit combination "0, 1" from each pair of mutually directly adjacent first logical circuit sections (LS1, LS2), the outputs of which exhibit a bit combination "1, −1", the sign bit of the most significant first circuit section (LS2) associated with this pair (LS1, LS2) being "0", the amount bit of this circuit section being "1", the sign bit of the least significant first circuit section (LS1) associated with this pair (LS1, LS2) being "1" and the amount bit of this latter circuit section being "1", whilst the bit combinations at the outputs of all remaining first logical circuit sections (LS0, LS3, LSN) are transferred unchanged into the CSD-coded output bit combination of the second logical circuit sections.

2. Circuit according to Claim 1, characterized in that each of the second logical circuit sections (LS1') exhibits four inputs (9 to 12) and two outputs (A11, A12), the inputs being supplied with the amount bit and the sign bit with an associated first logical circuit section (LS1) and the sign bit of the first logical circuit section (LS0) which is directly adjacent in the direction of least binary significances and the amount bit of the first logical circuit section (LS2) which is directly adjacent in the direction of most binary significances, that at one output (A11) a CSD-coded amount bit ($z_{v,1}$) can be picked up which corresponds to the input amount bit ($y_{v,1}$) when the sign bit ($y_{s,0}$) supplied from the adjacent first logical circuit section (LS0) consists of a logical "0" and corresponds to the negated input amount bit ($y_{v,1}$) when the last-mentioned sign bit ($y_{s,0}$) consists of a logical "1", and that at the other output (A12), a CSD-coded sign bit ($z_{s,1}$) can be picked up which corresponds to the sign bit ($y_{s,1}$) supplied from the associated first logical circuit section (LS1), when the amount bit $(y_{v,2})$ supplied from the adjacent first logical circuit section (LS2) consists of a logical "0", whilst it corresponds to the negated sign bit $(y_{s,1})$ supplied from the associated first logical circuit section (LS1) when the last-mentioned amount bit $(y_{v,2})$ consists of a logical "1".

3. Circuit according to Claim 1 or 2, characterized in that a first logical circuit section (LS1) contains an exclusive OR section (5) and a first AND section (7), two inputs of the exclusive OR section (5) representing the inputs (1, 2) of the logical circuit section (LS1), that the first input of the first AND section (7) is connected to the input (2) of this circuit section (LS1) to which the most significant bit $(x_1)$ is connected, that the second input of the first AND section (7) is connected to the output of the exclusive OR section (5) and that the output of the exclusive OR section (5) represents the output (6) for the amount bit $(Y_{v,1})$ whilst the output of the first AND section (7) forms the output (8) for the sign bit $(y_{s,1})$.

4. Circuit according to one of Claims 1 to 3, characterized in that a second logical circuit section (LS1') contains a second and a third AND section (15, 16), that the two inputs of the second AND section (15) are in each case connected to the output (8), provided for the sign bit $(y_{s,1})$, of an associated first logical circuit section (LS1) and via an inverter to the output (13), provided for the amount bit $(y_{v,2})$, of the directly adjacent first most significant logical circuit section (LS2), that the two inputs of the third AND section (16) are in each case connected to the output (6), provided for the amount bit $(y_{v,1})$, of the associated first logical circuit section (LS1) and via an inverter to the output (14), provided for the sign bit $(y_{s,0})$, of the directly adjacent first least significant logical circuit section (LS0), and that the output of the third AND section (16) represents the output (A11) for the CSD-coded amount bit $(z_{v,1})$ whilst the output of the second AND section forms the output (A12) for the CSD-coded sign bit $(z_{s,1})$.